# EUROPEAN PATENT APPLICATION

(11) **EP 1 925 964 A1**
(43) Date of publication of application: **28.05.2008**
(21) Application number: 07120976.1
(22) Date of filing: 19.11.2007
(51) Int. Cl.: G02B 26/10, B23K 26/08, B23K 26/40, H01L 21/78

(54) **Light scanning mechanism for scan displacement invariant laser ablation apparatus**

(30) Priority: 21.11.2006 US 562387
(71) Applicant: Palo Alto Research Center Incorporated, Palo Alto, California 94304 (US)
(72) Inventor: Curry, Douglas N., San Mateo, CA 94402 (US)
(74) Representative: Grünecker, Kinkeldey, Stockmair & Schwanhäusser Anwaltssozietät

(57) **Abstract**

A scanning/laser ablation apparatus includes an orbiting objective mounted on a radial arm that is rotated around a central axis such that the objective travels along a circular scan path. An input laser beam is directed along the central axis to a first mirror, which redirects the beam to the orbiting objective, e.g., by way of a second mirror. The orbiting objective focuses the beam at a focal point that coincides with the planar surface of a target object (e.g., a solar cell wafer having a blanket passivation layer). As the focused beam passes over the target object, the laser beam is repeatedly pulsed to ablate corresponding portions of the passivation layer such that contact openings are formed during each scan pass. The laser pulses are timed such that associated contact openings from multiple scan passes are aligned in parallel columns that are subsequently connected by metallization.

## Description

### FIELD OF THE INVENTION

This invention relates to the conversion of light irradiation to electrical energy, more particularly, to methods and tools for producing photovoltaic devices (solar cells) that convert solar energy to electrical energy.

### BACKGROUND OF THE INVENTION

Solar cells are typically photovoltaic devices that convert sunlight directly into electricity. Solar cells typically include a semiconductor (e.g., silicon) that absorbs light irradiation (e.g., sunlight) in a way that creates free electrons, which in turn are caused to flow in the presence of a built-in field to create direct current (DC) power. The DC power generated by several PV cells may be collected on a grid placed on the cell. Current from multiple PV cells is then combined by series and parallel combinations into higher currents and voltages. The DC power thus collected may then be sent over wires, often many dozens or even hundreds of wires.

The state of the art for metallizing silicon solar cells for terrestrial deployment is screen printing. Screen printing has been used for decades, but as cell manufacturers look to improve cell efficiency and lower cost by going to thinner wafers, the screen printing process is becoming a limitation. The screen printers run at a rate of about 1800 wafers per hour and the screens last about 5000 wafers. The failure mode often involves screen and wafer breakage. This means that the tools go down every couple of hours, and require frequent operator intervention. Moreover, the printed features are limited to about 100 microns, and the material set is limited largely to silver and aluminum metallizations.

The desired but largely unavailable features in a wafer-processing tool for making solar cells are as follows: (a) never breaks a wafer - e.g. non contact; (b) one second processing time (i.e., 3600 wafers/hour); (c) large process window; and (d) 24/7 operation other than scheduled maintenance less than one time per week. The desired but largely unavailable features in a low-cost metal semiconductor contact for solar cells are as follows: (a) Minimal contact area - to avoid surface recombination; (b) Shallow contact depth - to avoid shunting or otherwise damaging the cell's pn junction; (c) Low contact resistance to lightly doped silicon; and (d) High aspect metal features (for front contacts to avoid grid shading while providing low resistance to current flow).

Given the above set of desired features, the tool set for the next generation solar cell processing line is expected to look very different from screen printing. Since screen printing is an inherently low resolution contact method, it is unlikely to satisfy all of the criteria listed above. Solar cell fabrication is an inherently simple process with tremendous cost constraints. All of the printing that is done on most solar cells is directed at contacting and metallizing the emitter and base portions of the cell. The metallization process can be described in three steps, (1) opening a contact through the surface passivation, (2) making an electrical contact to the underlying silicon along with a robust mechanical contact to the solar cell and (3) providing a conducting path away from the contact.

Currently, the silver pastes used by the solar industry consist of a mixture of silver particles and a glass frit in an organic vehicle. Upon heating, the organic vehicle decomposes and the glass frit softens and then dissolves the surface passivation layer creating a pathway for silicon to reach the silver. The surface passivation, which may also serve as an anti-reflection coating, is an essential part of the cell that needs to cover the cell in all but the electrical contact areas. The glass frit approach to opening contacts has the advantage that no separate process step is needed to open the passivation. The paste mixture is screened onto the wafer, and when the wafer is fired, a multitude of random point contacts are made under the silver pattern. Moreover, the upper portions of the paste densify into a metal thick film that carries current from the cell. These films form the gridlines on the wafer's front-side, and the base contact on the wafer's backside. The silver is also a surface to which the tabs that connect to adjacent cells can be soldered. A disadvantage of the frit paste approach is that the emitter (sun-exposed surface) must be heavily doped otherwise the silver cannot make good electrical contact to the silicon. The heavy doping kills the minority carrier lifetime in the top portion of the cell. This limits the blue response of the cell as well as its overall efficiency.

In the conventional screen printing approach to metallizing solar cells, a squeegee presses a paste through a mesh with an emulsion pattern that is held over the wafer. Feature placement accuracy is limited by factors such as screen warpage and stretching. The feature size is limited by the feature sizes of the screen and the rheology of the paste. Feature sizes below 100 microns are difficult to achieve, and as wafers become larger, accurate feature placement and registration becomes more difficult. Because it is difficult to precisely register one screen printed pattern with another screen printed pattern, most solar cell processes avoid registering multiple process steps through methods like the one described above in which contacts are both opened and metallized as the glass frit in the silver paste dissolves the nitride passivation. This method has numerous drawbacks however. Already mentioned is the heavy doping required for the emitter. Another problem is a narrow process window. The thermal cycle that fires the gridline must also burn through the silicon nitride to provide electrical contact between the silicon and the silver without allowing the silver to shunt or otherwise damage the junction. This severely limits the process time and the temperature window to a temperature band on the order of 10 degrees C about a set point of 850C and a process time of on the order of 30 seconds. However, if one can form a contact opening and register metallization of the desired type, a lower contact resistance can be achieved with a wider process margin.

The most common photovoltaic device cell design in production today is the front surface contact cell, which includes a set of gridlines on the front surface of the substrate that make contact with the underlying cell's emitter. Ever since the first silicon solar cell was fabricated over 50 years ago, it has been a popular sport to estimate the highest achievable conversion efficiency of such a cell. At one terrestrial sun, this so-called limit efficiency is now firmly established at about 29% (see Richard M. Swanson, "APPROACHING THE 29% LIMIT EFFICIENCY OF SILICON SOLAR CELLS" 31s IEEE Photovoltaic Specialists Conference 2005). Laboratory cells have reached 25%. Only recently have commercial cells achieved a level of 20% efficiency. One successful approach to making photovoltaic devices with greater than 20% efficiency has been the development of backside contact cells. Backside contact cells utilize localized contacts that are distributed throughout p and n regions formed on the backside surface of the device wafer (i.e., the side facing away from the sun) to collect current from the cell. Small contact openings finely distributed on the wafer not only limit recombination but also reduce resistive losses by serving to limit the distance carriers must travel in the relatively less conductive semiconductor in order to reach the better conducting metal lines.

One route to further improvement is to reduce the effect of carrier recombination at the metal semiconductor interface in the localized contacts. This can be achieved by limiting the metal-semiconductor contact area to only that which is needed to extract current. Unfortunately, the contact sizes that are readily produced by low-cost manufacturing methods, such a screen printing, are larger than needed. Screen printing is capable of producing features that are on the order of 100 microns in size. However, features on the order of 10 microns or smaller can suffice for extracting current. For a given density of holes, such size reduction will reduce the total metal-semiconductor interface area, and its associated carrier recombination, by a factor of 100.

The continual drive to lower the manufacturing cost of solar power makes it preferable to eliminate as many processing steps as possible from the cell fabrication sequence. As described in US Published Application No. US20040200520 A1 by SunPower Corporation, typically, the current openings are formed by first depositing a resist mask onto the wafer, dipping the wafer into an etchant, such a hydrofluoric acid to etch through the oxide passivation on the wafer, rinsing the wafer, drying the wafer, stripping off the resist mask, rinsing the wafer and drying the wafer.

What is needed is a method and system for producing photovoltaic devices (solar cells) that overcomes the deficiencies of the conventional approach described above by both reducing the manufacturing costs and complexity, and improving the operating efficiency of the resulting photovoltaic devices.

### SUMMARY OF THE INVENTION

The present invention is directed to a method and system for producing photovoltaic devices (solar cells) that overcomes deficiencies of conventional approaches by providing a non-contact patterning process using a laser scanning mechanism that avoids displacement aberrations and off-axis focusing errors, thereby reducing the manufacturing costs and complexity associated with the production of the photovoltaic devices using conventional techniques, and improving the operating efficiency of the resulting photovoltaic devices.

In accordance with a central aspect of the present invention, the laser ablation apparatus utilizes a novel light (e.g., laser) scanning mechanism that may be used in a wide range of applications other than the micro-machining embodiment described herein. In particular, the light scanning mechanism redirects a light beam that is transmitted along a central axis such that the light beam remains on-axis and in focus as it is scanned along a curved (e.g., circular) scan path. The light scanning mechanism includes a rotating member having a base (first) portion disposed to rotate around the central axis (i.e., the axis of rotation of the rotating member is collinear with the optical axis of the transmitted beam), and a head (second) portion disposed away from the central axis. A first mirror is disposed on the rotating member at the base portion and arranged to redirect the light beam from the central axis toward the head portion when the rotating member is in any angular position. A second mirror mounted at the head portion is arranged to redirect the light beam received from the first mirror through an objective lens (focusing element) in a predetermined direction (e.g., parallel to the central axis). As the rotating member is turned around the central axis, the light beam (which is focused by the objective lens) traces a curved (e.g., circular) scan path on a target surface. When the target surface is parallel to the plane defined by the orbiting objective lens, the light beam remains on-axis and maintains a fixed focus at any angular position of the orbiting objective lens. Thus, the present invention provides a light scanning mechanism that eliminates off-axis focusing errors that arise in conventional polygon raster output scanner (ROS) devices. Further, the rotating objective scanning mechanism is relatively inexpensive to produce and relatively robust and reliable.

In accordance with a practical embodiment of the present invention, the light scanning mechanism of the present invention is implemented using a high power (e.g., femto-second) laser device and a movable stage mechanism to produce a highly efficient laser ablation apparatus that can be used, for example, to ablate (remove) a material that is disposed (e.g., deposited) on a flat surface of a target object (e.g., a substrate or wafer). The target object is mounted on the movable stage in a predetermined orientation, and the stage is positioned such that the orbiting objective lens passes over the target object in a curved scan path that is substantially perpendicular to the predetermined stage movement direction. As the orbiting objective passes over the target object, the laser is selectively actuated to generate a high energy pulse that ablates a selected portion of the material. Because the laser beam remains on-axis and in focus at every angular position along the scan path, the laser ablation apparatus can be utilized to efficiently and reliably ablate material from multiple locations along each scan path in a manner that avoids the off-axis and defocused beam problems associated with ROS devices. Upon completion of each scan path, the stage is moved an incremental amount in the predetermined movement direction such that the orbiting objective is positioned over a different portion of the target object during each subsequent scanning pass. By systematically moving the target object in this manner, the ablation process is performed over the entire two dimensional surface of the target object.
In one embodiment of the laser ablation apparatus of Claim 8, the first optical element is disposed at a fixed distance from the second optical element, and
wherein the focusing element is disposed at a fixed distance from the second optical element.
In a further embodiment said means for controlling the laser device comprises an electronic registration device disposed adjacent to the stage.
In a further embodiment the laser ablation apparatus further comprises means for moving the stage a predetermined distance in a predetermined direction after the predetermined portion of the selected material is ablated.

In accordance with a specific embodiment of the present invention, a system for producing photovoltaic devices (e.g., solar cells) utilizes the laser ablation apparatus to form contact openings through a passivation layer formed on a semiconductor substrate that has been processed to include parallel elongated doped (diffusion) regions, and also uses a direct-write metallization apparatus to deposit conductive (e.g., metal) contact structures into the contact openings and to form metal lines that extend between the contact structures on the passivation layer. The parallel elongated doped regions define the moving direction of the stage between each scan pass such that the objective passes over several doped regions during each scan path. Timing of the laser pulses is controlled, e.g., using an electronic registration device, such that a series of contact openings are defined through the passivation material that extend along each of the doped regions. By utilizing orbiting objective laser ablation apparatus to define the contact openings, the present invention facilitates the formation of smaller openings with higher precision, thus enabling the production of an improved metal semiconductor contact structure with lower contact resistance and a more optimal distribution of contacts. After the contact holes are generated, the partially processed semiconductor substrate is passed through the direct-write metallization apparatus (e.g., an ink-jet type printing apparatus) in the stage movement direction such that contact structure are formed in each contact hole and conductive (e.g., metal) lines are printed on the passivation material over the elongated doped regions to form the device's metallization (current carrying conductive lines). By utilizing a direct-write metallization apparatus to print the contact structures and conductive lines immediately after forming the contact holes, the present invention provides a highly efficient and accurate method for performing the metallization process in a way that minimizes wafer oxidation. This invention thus both streamlines and improves the manufacturing process, thereby reducing the overall manufacturing cost and improving the operating efficiency of the resulting photovoltaic devices.
In one embodiment of the system of claim 10, the first and second optical elements comprise mirrors having respective flat reflective surfaces that are parallel, and
wherein the focusing element comprises an objective lens disposed between the second mirror and the focal point.
In a further embodiment the first optical element is disposed at a fixed distance from the second optical element, and
wherein the focusing element is disposed at a fixed distance from the second optical element.
In a further embodiment said means for controlling the laser device comprises an electronic registration device disposed adjacent to the stage.
In a further embodiment system further comprises means for moving the stage a predetermined distance in a direction parallel to the elongated doped regions after the predetermined portion of the passivation layer is ablated.
In a further embodiment the system further comprises a direct-write metallization apparatus including:
means for depositing a conductive material into each of the plurality of contact openings;
means for moving the semiconductor substrate in the direction parallel to the elongated doped regions.
In a further embodiment the laser device is a femto-second laser device.

### BRIEF DESCRIPTION OF THE DRAWINGS

These and other features, aspects and advantages of the present invention will become better understood with regard to the following description, appended claims, and accompanying drawings, where:

Figs. 1(A) and 1(B) are top and side elevation views showing a simplified light scanning mechanism according to an embodiment of the present invention;

Fig. 2 is a flow diagram showing a simplified method for producing photovoltaic devices according to an embodiment of the present invention;

Fig. 3 is a simplified diagram showing a system for producing photovoltaic devices according to another embodiment of the present invention;

Figs. 4(A) and 4(B) are top plan and side elevation views depicting a simplified semiconductor substrate prior to laser ablation;

Fig. 5 is a perspective view showing a laser ablation apparatus according to another embodiment of the present invention;

Fig. 6 is a top plan view showing the laser ablation apparatus of Fig. 5 prior to operation according to another embodiment of the present invention;

Figs. 7(A), 7(B) and 7(C) are top plan views showing the laser ablation apparatus of Fig. 5 during operation according to the embodiment of Fig. 6;

Figs. 8(A) and 8(B) are plan and partial perspective views showing a semiconductor substrate after laser ablation;

Fig. 9 is a plan view showing a semiconductor substrate during direct-write metallization according to another aspect of the present invention; and

Fig. 10 is a partial perspective view showing the semiconductor substrate of Fig. 9 after direct-write metallization.

### DETAILED DESCRIPTION OF THE DRAWINGS

The present invention relates to an improvement in photovoltaic devices (e.g., solar cells) that can be used, for example, to convert solar power into electrical energy. The following description is presented to enable one of ordinary skill in the art to make and use the invention as provided in the context of a particular application and its requirements. As used herein, directional terms such as "upper", "lower", "side", "front", "rear", are intended to provide relative positions for purposes of description, and are not intended to designate an absolute frame of reference. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

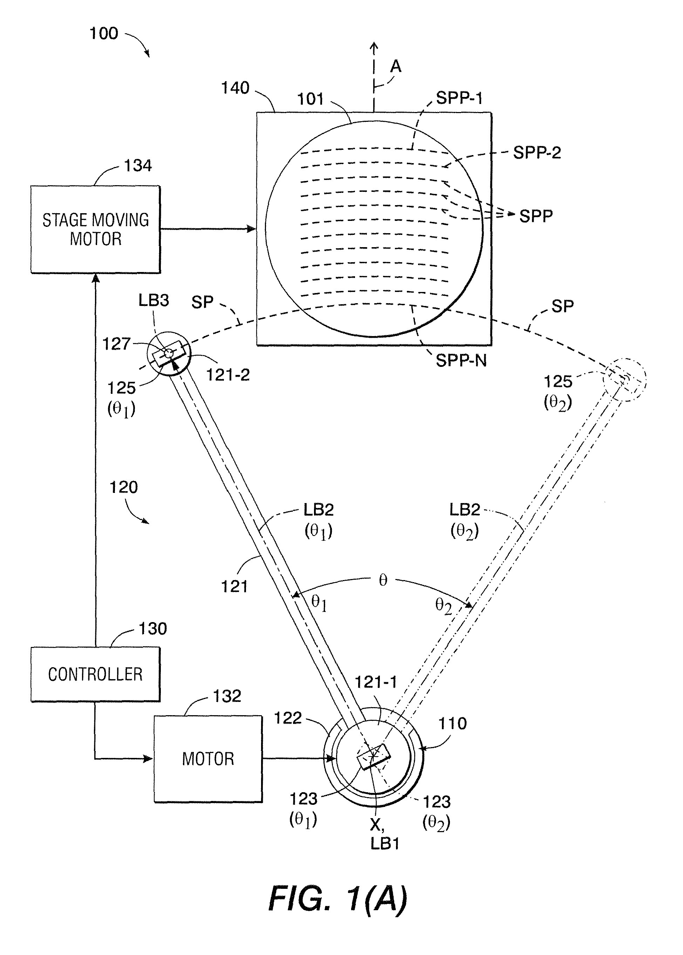

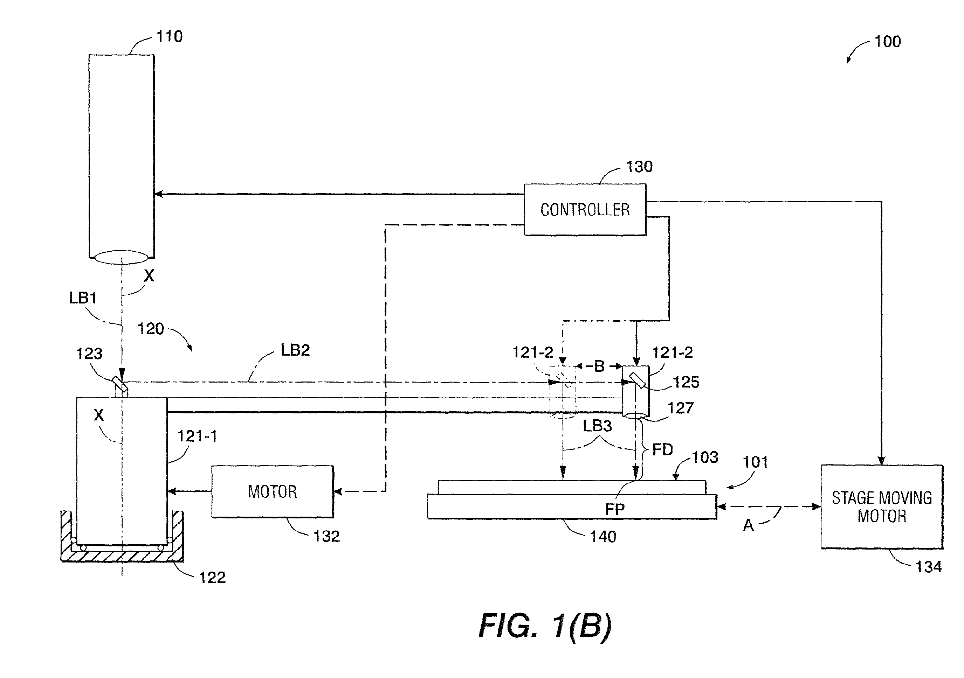

Figs. 1(A) and 1(B) are top and side elevation views showing a system 100 including a light scanning mechanism 120 that is used to scan a light (e.g., laser) beam received from a stationary light source 110 over the surface of a target object 101. As described below, light scanning mechanism 120 is utilized in one embodiment to perform non-contact micro-machining (i.e., laser ablation patterning of a passivation layer) in the production of solar cells, thus avoiding the problems associated with conventional screen patterning techniques. The contact openings generated by laser-based ablation devices are substantially smaller than the minimum openings produced by conventional screen printing processes. The laser-based ablation device also facilitates removal of the passivation without significantly altering the thickness or doping profile of the underlying silicon layer. In a specific embodiment, light source 110 is a femto-second laser, which facilitates shallow ablation with a minimum of debris. A particular advantage of femto-second laser pulses is that the power density can be sufficiently high that the electric field of the optical pulse becomes comparable to the inter-atomic fields of the atoms in the material. This becomes important in the present application because it is desired to ablate the passivation without disturbing the underlying semiconductor. The passivation is typically Silicon Nitride having a thickness of 800 angstroms, and as such has a large band gap and it typically transparent. Ordinarily, light would pass through the passivation and become adsorbed by the underlying semiconductor. With sufficiently high power density, the interaction of light with matter alters such that even ordinarily transparent materials become adsorbing. Multiple photons can be adsorbed on a site in the material before the excited electronic states can relax. By adsorbing energy in the dielectric passivation, the surface layer can be selectively ablated. For a photovoltaic device with a shallow layer of dopants, this selective surface ablation is advantageous. The n-type emitter of a typical screen printed solar cell for example is only about 200 to 300 nm thick. If an ablated contact opening in the passivation were to extend through the emitter, then the metallization could form a shunt to the p-type material below the emitter, ruining the device.

Although the present invention is described herein with specific reference to the production of photovoltaic devices, those skilled in the art will recognize that laser ablation apparatus 100 may be utilized to process many different target objects. Therefore, unless otherwise specified in the appended claims, the present invention is not intended to be limited by the specific embodiment described herein.

As described in detail below, a key aspect of light scanning mechanism 120 is that the light (laser) beam remains on-axis and in focus throughout the scan path traced by the mechanism. As such, light scanning mechanism 120 exhibits superior characteristics to conventional ROS-based light scanning mechanism, which scan a light beam using a polygonal, multi-facet mirror device. As mentioned above, light source 110 is preferably a femto-second laser device when light scanning mechanism 120 is used for producing solar cells because the passivation layer typically used on solar cells is light transparent. Unfortunately, the extremely short pulse width of 100 x 10⁻¹⁵ seconds makes femto-second laser beams non-mono-chromatic, increasing the difficulty in creating a low aberration scanning beam. When a ROS-based scanning mechanism is used, this problem is compounded by the requirement for a ten micron spot over a five inch scan using a large field lens and rotating polygon. These elements introduce off-axis distortion, off-axis dispersion, off-axis non-telecentricity, off-axis depth-of-field differences, and off-axis chromatic aberrations. It may not be possible to reliably ablate even after correcting for these problems. As set forth below, light scanning mechanism 120 overcomes the problems associated with ROS-based scanning mechanisms by maintaining the laser beam on-axis and in focus throughout its scan path.

Light scanning mechanism 120 generally includes a rotating member 121, a first optical element (e.g., mirror) 123, a second optical element (e.g., mirror) 125, and a focusing element (e.g., a microscope objective lens) 127, which is sometimes referred to below as an "orbiting objective" for reasons that will become clear below. Rotating member 121 includes a base (first) portion 121-1 disposed to rotate around a central axis X, a head (second) portion 121-2 disposed away from central axis X, and an intermediate portion extending radially between base portion 121-1 and head portion 121-2. As indicated in Fig. 1(B), an input light beam (first light beam portion) LB1 generated by light source 110 is transmitted along central axis X. Note that the axis of rotation of rotating member 121 is collinear with the optical axis of input light beam LB1, and therefore these two axes are referred to herein as central axis X. As shown in Fig. 1(B), in one embodiment base portion 121-1 is a cylindrical axle-like structure that is rotatably supported on a base 122 by way of suitable bearings, and intermediate portion is a rod-like structure that is fixedly connected between base portion 121-1 and head portion 121-2. Those skilled in the art will recognize that rotating member 121 can take a wide variety of forms and shapes. First optical element 123 is disposed on rotating member 121 on base portion 121-1, and is arranged to intersect central axis X when rotating member 121 is in any angular position (e.g., angular positions θ₁, θ₂, or any angular position between angular positions θ₁, θ₂). In addition, first optical element 123 is arranged to continuously redirect the light beam from central axis X toward head portion 121-2 when the rotating member is rotated between any two angular positions. In the present exemplary embodiment, as depicted in Fig. 1(B), first optical element 123 is a flat mirror disposed such that a plane defined by the mirror surface forms a 45° angle with respect to central axis X, whereby the vertical input light beam LB1 transmitted along central axis X is redirected horizontally toward head portion 121-2, thereby forming a second light beam portion LB2 between mirror 123 and second optical element 125. Similarly, in one embodiment, second optical element 125 is a flat mirror mounted on head portion 121-2 such that a plane defined by the mirror surface is disposed parallel to that of first mirror 123, and forms a 45° angle with respect to horizontal light beam portion LB2, whereby second mirror 125 redirects light beam portion LB1 vertically downward to form a third light beam portion LB3 that is directed parallel to central axis X (and input light beam LB1).

For a flat output field, LB1 should be parallel with LB3. It should be noted that first 45 degree mirror 123 and second 45 degree mirror 125 together create two ninety degree bends in the light path as the beam travels to its destination. The resulting light beam LB3 is parallel with the optical axis LB1. Those skilled in the art will recognize that the two mirrors are not restricted to this particular angle, and that other angles are available. For instance, if both mirrors were angled at 30 degrees, the mirrors would create two sixty degree bends in the light path as the beam travels to its destination, resulting in light beam LB3 parallel with the input beam LB1.

In accordance with an aspect of the present invention, because optical elements 123 and 125 maintain a fixed relationship on rotating member 121, the vertical light beam generated by light source 110 is reliably transmitted to focusing element 127 when rotating member 121 is in any angular position relative to central axis X. As indicated in Fig. 1(A), when rotating member 121 is at angular position θ₁, first optical element 123 is disposed in position 123(θ₁), whereby second light beam portion LB2(θ₁) is directed to second optical element 125, which is in position 125(θ₁). Because first optical element 123 and second optical element 125 are fixedly connected to rotating member 121 and first optical element 123 intersects central axis X, first optical element 123 continues to redirect (e.g., reflect) input light beam LB1 as rotating member 121 pivots through angle θ. In addition, when first optical element 123 rotates from position 123(θ₁) to position 123(θ₂), second light beam portion LB2(θ₂) is directed to second optical element 125, which has at that time assumed position 125(θ₂). Accordingly, the input light beam LB1 generated by light source 110 is transmitted to focusing element 127 when rotating member 121 is in any angular position relative to central axis X.

In accordance with another aspect of the present invention, the light beam is reliably focused on target object 101 because the distance traveled by the light beam between light source 110 and target object 101 remains constant for all angular positions of rotating member 121. First, as indicated in Fig. 1(B), the distances traveled by input light beam LB1 (i.e., between light source 110 and first optical element 123) and light beam portion LB3 (i.e., between second optical element 125 and planar surface 103 of target object 101) remain constant for any position of rotating member 121. In addition, as indicated in Fig. 1(A), the distance traveled by third light beam portion LB2 (i.e., between first optical element 123 and second optical element 125) remains constant when rotating member 121 is in any angular position relative to central axis X. In addition, as indicated in Fig. 1(B), focusing element 127 is disposed below second optical element 125 (i.e., such that third light beam portion LB3 passes through focusing element 127), and is sized and positioned according to known techniques such that third light beam portion LB3 is focused at a focal point FP that is a predetermined fixed distance FD below focusing element 127. In one embodiment, as shown in Fig. 1(B), planar upper surface 103 of target object 101 is positioned at focal distance FD below focusing element 127. Because the length of each light beam portion LB1, LB2 and LB3 remain fixed, the total distance between light source 110 and focal point FP remains constant at any position along scan path SP. Thus, the light beam remains on-axis during each of light beam portions LB1, LB2 and LB3, and the point of light striking upper surface 103 maintains a fixed focus when rotating member 121 is in any angular position. Thus, light scanning mechanism 120 eliminates off-axis focusing errors and displacement aberrations that arise in conventional polygon ROS devices. Further, light scanning mechanism 120 is relatively inexpensive to produce and relatively robust and reliable when compared with conventional ROS devices.

In accordance with an embodiment of the present invention, system 100 utilizes an optional control circuit 130 and a suitable first motor 132 to control the rotation of rotating member 121 around central axis X, and to also control a stage moving motor 134 such that target object 101 is moved after each scan pass. In one embodiment, target object 101 is mounted on a stage 140 whose linear movement in the direction A (indicated by dashed-line arrow in Fig. 1(A)) is controlled by stage moving motor 134, and first motor 132 is actuated to cause rotating member 120 to continually rotate, for example, in a clockwise direction such that the focused light beam traverses a scan pass portion SPP on target object 101 during each scan pass (i.e., each time focusing element 127 passes over target object 101). While rotating member 121 is thus rotating, stage 140 is systematically shifted in the direction A by a predetermined distance after each scan pass, thus causing the scan pass portions SPP traversed during each revolution to be located over an associated (unique) portion of target object 101. For example, focusing element 127 passes over a first scan path portion SPP1 during a first pass, then stage 140 is shifted, which causes focusing element 127 to pass over a second scan path portion SPP2 during the second (next sequential) scan pass. As indicated in Fig. 1(A), by shifting target object 101 after each scan pass, the resulting collection of scan path portions SPP traversed by the focused light beam on target object 101 form the two dimensional (2D) space that covers the surface of target object 101. As described in additional detail below, the curved scan path SP traversed by light scanning mechanism 120 can be just as useful as straight scans generated, for example, by conventional ROS devices.

In accordance with a practical embodiment of the present invention, light scanning mechanism 120 is utilized as a highly efficient laser ablation apparatus that can be used, for example, to produce photovoltaic devices (solar cells) in the manner described below. In particular, because the laser (light) beam remains on-axis and reliably focused during all points along the scan path, light scanning mechanism 120 provides robust and repeatable ablation performance. It is noted that the objective still has to focus the beam at an appropriate height from the surface, but the present invention makes this focusing issue more manageable, in comparison to conventional ROS devices. Although the laser ablation apparatus is described herein with specific reference to the production of photovoltaic devices, those skilled in the art will recognize that the laser ablation apparatus may be utilized in multiple practical applications.

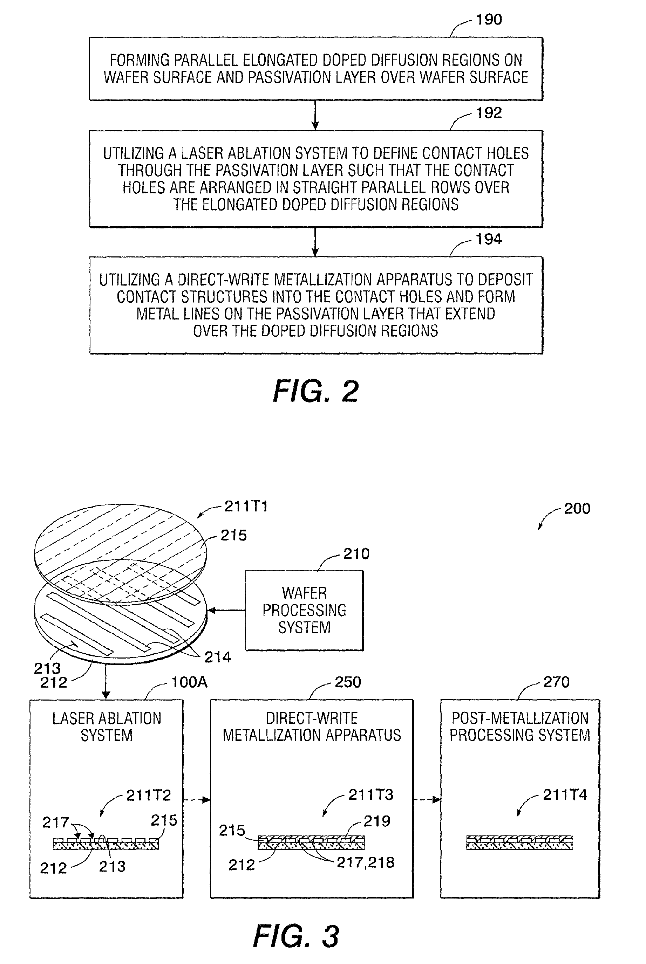

Figs. 2 and 3 depict the solar cell fabrication process associated with the present invention. Fig. 2 is a flow diagram indicating the basic processing steps utilizing light scanning apparatus 100 (described above) as a laser ablation apparatus 100A to produce photovoltaic devices in accordance with an embodiment of the present invention. Fig. 3 is a simplified block diagram illustrating a system 200 for processing photovoltaic devices using laser ablation system 100A in accordance with another embodiment of the present invention.

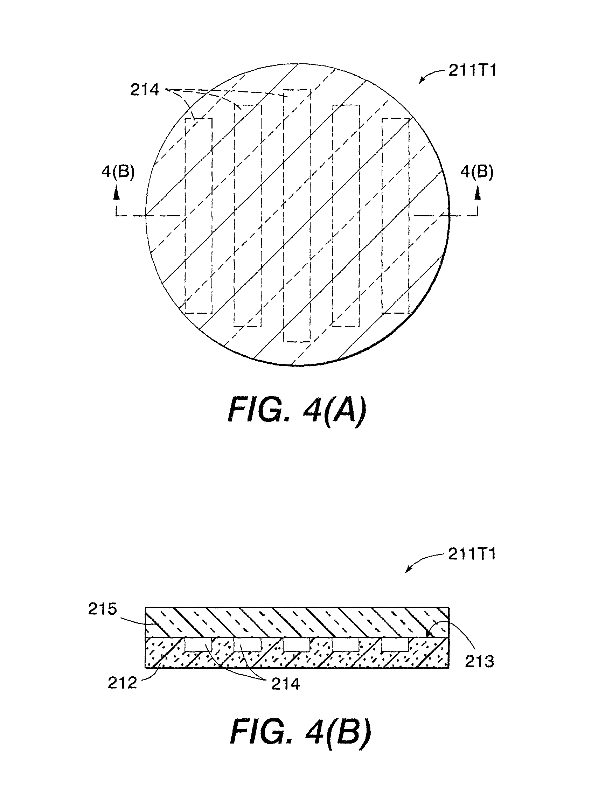

Referring to block 190 of Fig. 2 and to Figs. 3, 4(A) and 4(B), the method proposed herein begins by processing a semiconductor (e.g., monocrystalline or multi-crystalline silicon) substrate 212 using known photolithographic or other known techniques such that several parallel elongated doped diffusion regions 214 are disposed in an upper surface 213 thereof, and substrate 212 is further treated to include a blanket passivation (electrically insulating) layer 215 that is disposed on upper surface 213 over doped regions 214. As referred to herein, the photovoltaic device is generally as "device 211", and at each stage of the processing cycle is referenced with an appended suffix indicating the device's current processing stage (e.g., prior to the ablation process described below, device 211 is referenced as "device 211T1", with the suffix "T1" indicating a relatively early point in the process cycle). The operations used to provide device 211T1 with doped regions 214 and covering surface 213 with passivation layer 215 (block 190 in Fig. 2) are performed using well-known processing techniques, and thus the equipment utilized to produce device 211T1 is depicted generally in Fig. 3 as wafer processing system block 210.

After initial treatment, device 211T1 is transferred to laser ablation apparatus 100A, which is utilized to define contact holes 217 through passivation layer 215 that expose corresponding portions of upper surface 213 of substrate 212 such that the contact holes are arranged in straight parallel rows over the doped diffusion regions (block 192). The ablation process is described in additional detail below.

After contact holes 217 are defined through passivation layer 215, wafers 211T2 are passed to a direct-write metallization apparatus 250 that is utilized to deposit contact structures 218 into contact holes 217, and to form metal interconnect lines 219 on passivation layer 215 such that each metal interconnect line 219 connects the contact structures 218 disposed over an associated doped diffusion region (block 194). As used herein, "direct-write metallization device" is defined as a device in which the metallization material is ejected, extruded, or otherwise deposited only onto the portions of the substrate where the metallization is needed (i.e., without requiring a subsequent mask and/or etching process to remove some of the metallization material). After the metallization process is completed, device 211T3 is passed from direct-write metallization apparatus 250 to an optional post-metallization processing system 270 for subsequent processing to form the completed device 211T4.

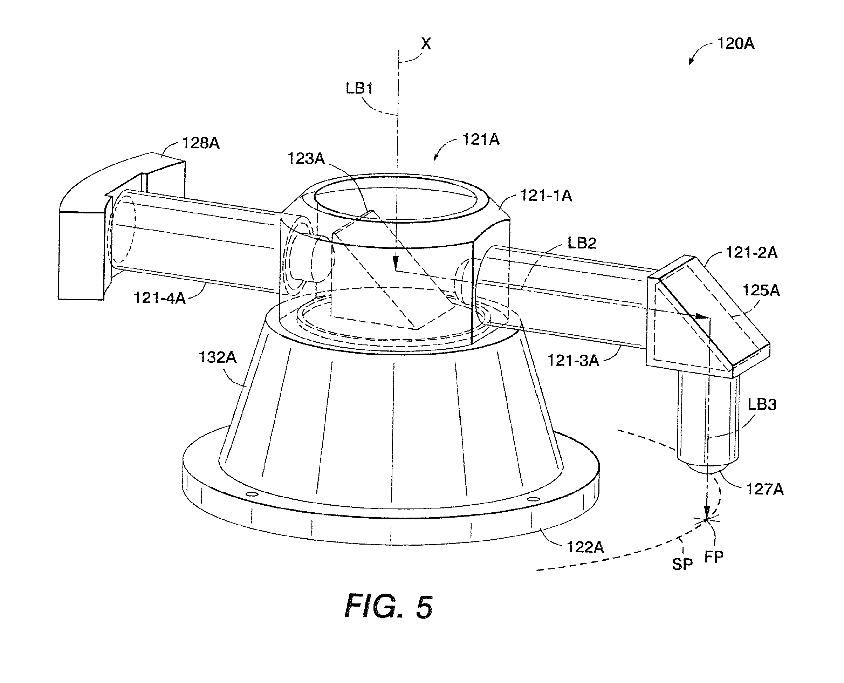

Fig. 5 is a perspective view showing a laser scanning mechanism 120A that is utilized in laser ablation system 100A of Fig. 3. An input laser beam LB1 is transmitted along central axis X by a laser device (not shown) in the manner described above with reference to Figs 1(A) and 1(B)). Laser scanning mechanism 120A generally includes a rotating member 121A, a first mirror 123A, a second mirror 125, and an objective lens 127A. Rotating member 121A includes a generally cylindrical base (first) portion 121-1A that is mounted on a fixed base portion 122A and is disposed to rotate around central axis X in accordance with a motor 132A. Base portion 121-1A supports first mirror 123A in a manner similar to that described above. Rotating member 121A also includes a head (second) portion 121-2A that supports second mirror 125A, and a rigid, tubular central portion 121-3A that is connected between base portion 121-1A and head portion 121-2A. First mirror 123A is arranged to continuously reflect input laser beam LB1 from central axis X to second mirror 125A along second laser beam portion LB2 that passes through a central axial region of tubular central portion 121-3A. Second mirror 125A is disposed parallel to first mirror 123A, and reflects horizontal laser beam portion LB2 vertically downward to form a third laser beam portion LB3 that is directed parallel to central axis X. In the present invention, third laser beam portion LB3 passes through objective lens 127A, which focuses the laser beam at a focal point FP that is a predetermined distance below objective lens 127A. Similar to the generalized embodiment described above with reference to Figs. 1(A) and 1(B), rotation of rotating member 121A causes focal point FP to travel along a curved scan path SP that defines a plane.

In accordance with another aspect of the present embodiment, rotating member 121A further includes a second tubular portion 121-4A extending from base portion 121-lA, and a counterweight 128A fixedly connected to an end of second tubular portion 121-4A and disposed such that base portion 121-1A is located between counterweight 128A and head portion 121-2A. Counterweight 128A facilitates high speed rotation of orbiting objective 127A, thus facilitating the high speed manufacture of photovoltaic devices.

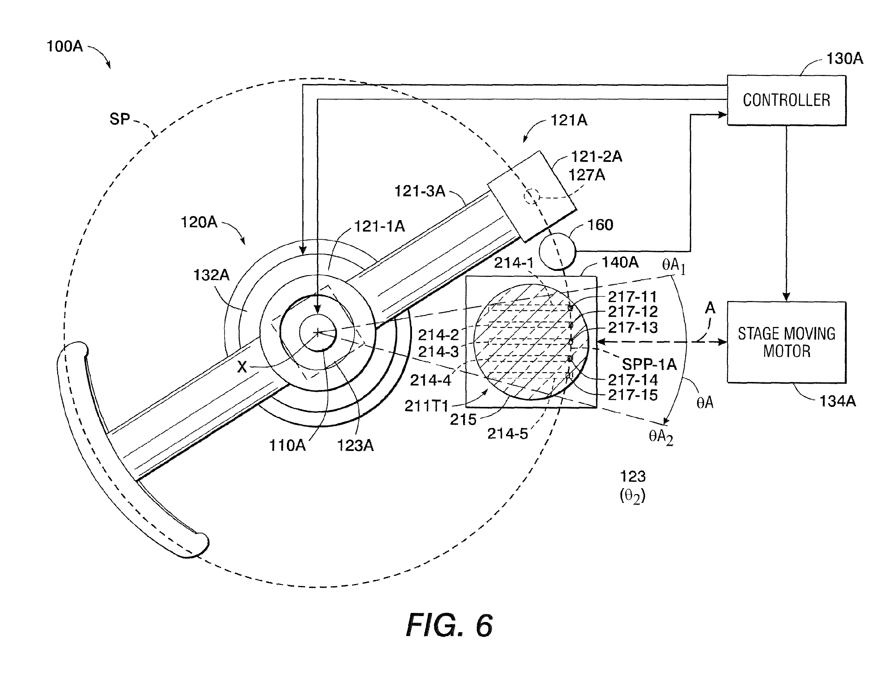

Fig. 6 is a plan view showing laser ablation apparatus 100A prior to ablating selected portions of passivation material 215 from device 211T1. Similar to the scanner apparatus described above, laser ablation apparatus 120A includes a controller (e.g., a microprocessor and associated software) 130A for controlling rotational motor 132A, a stage moving motor 134A, and laser 110A. In one embodiment, controller 130A controls motor 132A to spin rotating member 121A at a constant rotational speed around central axis X such that the focal point defined by optical element 127A traces a circular scan path SP. In addition, controller 130A controls stage moving motor 134A to position stage 140A such that scan path SP traces a first curved path (referred to herein as a scan path portion) SPP-1A across the surface of passivation layer 215 when head portion 121-2A is rotated through an angle θA, which extends between a first angular position θA₁ and a second angular position θA₂. As optical element 127A passes over device 211T1, controller 130A causes laser 110A to selectively generate a high energy pulses that ablate corresponding portions of passivation layer 215, thereby forming a series of contact openings 217-11 to 217-15 along scan path portion SPP-1A.

In accordance with an embodiment of the present invention, laser beam pulses are precisely timed using an electronic registration device 160 such that contact openings 217-11 to 217-15 expose portions of doped regions 214-1 to 214-5, respectively. In one embodiment, electronic registration device 160 comprises a sensor that is disposed on or next to stage 140A, and sends a detection signal to controller 130A each time head portion 121-2A passes over sensor device 160. Controller 130A then utilizes the detection signal and information regarding the rotational speed of rotating member 120A to affect precise timing of the laser pulses such that contact openings 217-11 to 217-15 are formed over doped regions 214-1 to 214-5, respectively. Suitable sensors are known to those skilled in the art.

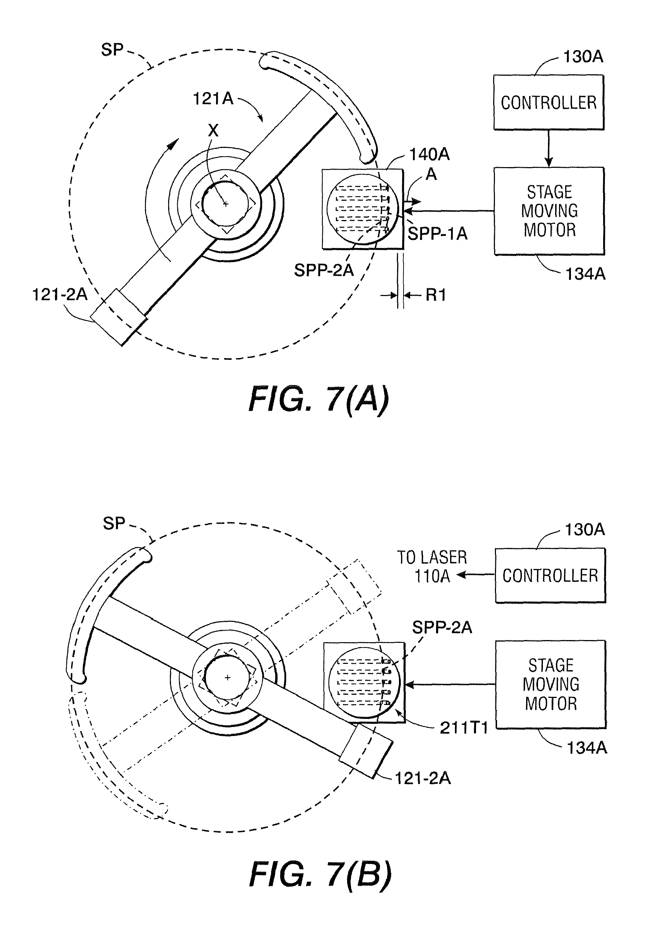

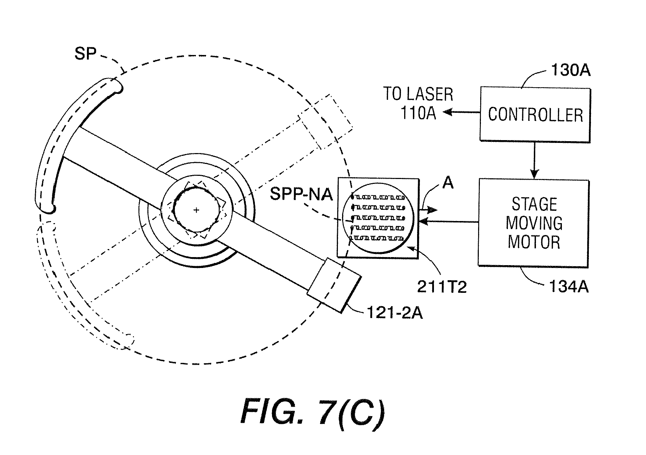

In accordance with another aspect of the present invention, electronic registration device 160 is used in conjunction with stage moving motor 134A to compensate for the curved scan path SP, thus producing straight rows/columns of contact openings that are respectively aligned with doped regions 214-1 to 214-5. To produce this alignment, as shown in Fig. 6, device 211T1 is mounted on stage 140A such that elongated doped regions 214-1 to 214-5 are aligned in moving direction A (i.e., such that scan path SP is substantially perpendicular to elongated doped regions 214). Electronic registration device 160 is then utilized during a first scan pass to generate contact openings 217-11 to 217-15 over doped regions 214-1 to 214-5 in the manner described above. Next, as indicated in Fig. 7(A), during subsequent rotation of rotating member 121A in the clockwise direction (i.e., while head portion 121-2A is positioned away from device 211T1), controller 130A actuates stage moving motor 134A, which in turn causes stage 140A to move an incremental amount R in the moving direction A (i.e., in a radial direction away from central axis X). Subsequently, as depicted in Fig. 7(B), when head portion 211-2A again passes over device 211T1, controller 130A actuate the laser device (not shown) to generate a second row of contact openings along scan path portion SPP-2A. As indicated in Fig. 7(C), this process of incrementally moving stage 140A and actuating the laser device to generate rows of contact openings is repeated until a final row of contact holes is generated during a final scan SPP-NA. At this point the ablation process is completed, and device 211T2 has the desired two dimensional contact hole pattern. Referring to Fig. 3, device 211T2 is then transferred to direct-write metallization apparatus producing (i.e., a device that is now ready for metallization, discussed below).

It is noted that, as shown in Figs. 7(A) to 7(C), head portion 121-2A is active over device 211T1 for only a small portion of circular scan path SP. In an alternative embodiment disclosed in co-owned and co-filed U.S. Patent Application No. xx/xxx,xxx entitled "MULTIPLE STATION LASER ABLATION APPARATUS" [Atty Docket No. 20060269-US/NP(XCP-075)], which is incorporated herein by reference in its entirety, a plurality of devices 211T1 are stationed around central axis X, thereby minimizing the otherwise significant inactive period between scan passes over a single device.

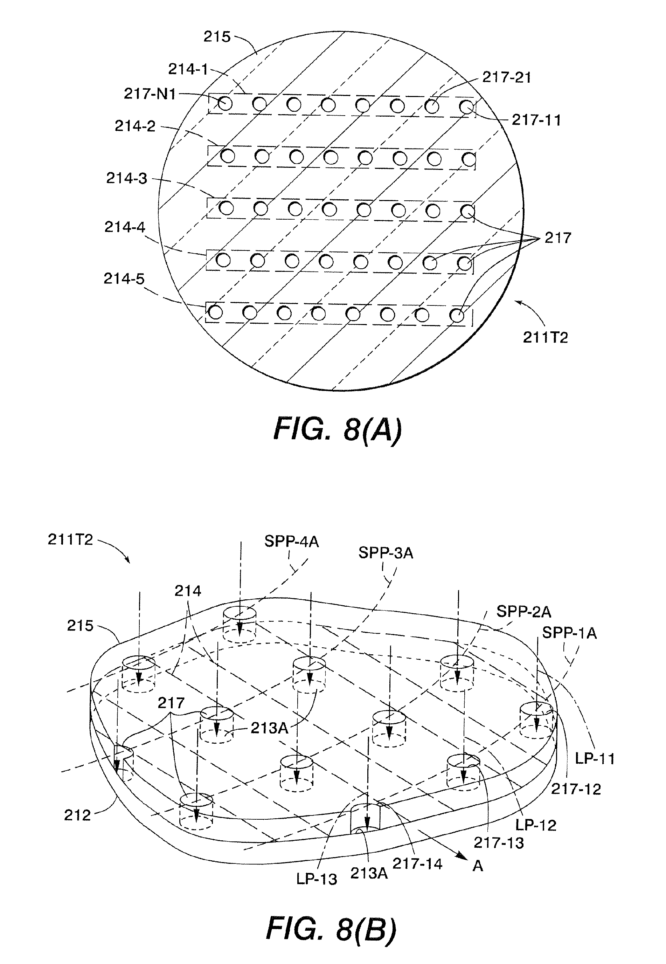

Figs. 8(A) and 8(B) show device 211T2 upon completion of the ablation process depicted in Figs. 7(A) to 7(C). As indicated in Fig. 8(A), the two dimensional pattern defined by contact openings 217 includes straight columns that extend along corresponding doped regions 214-1 to 214-5. For example, contact hole 217-11 formed during a first scan pass is aligned with contact hole 217-21 formed during a second scan pass and contact hole 217-N1 formed during an Nth scan pass. As indicated by vertical dashed lines in Fig. 8(B), the laser pulses generated during sequential scan passes SPP-1A to SPP-4A ablate (remove) associated portions of passivation layer 215 to form contact openings 217 that expose surface portions 213A of substrate 212 over doped regions 214 without the need for cleaning or other processing prior to metallization. For example, laser pulses LP-11 to LP-13 are generated during scan pass SPP-1A to form contact openings 217-12, 217-13 and 217-14, respectively, which in turn expose corresponding surface portions 213A on respective doped regions 214. Thus, an advantage of using laser ablation over other contact opening methods such as chemical etching, is that substrate 212 need not be rinsed and dried after the ablation is performed. Avoidance of rinsing and drying steps enables the rapid and successive processing of the contact opening following by the metallization. The avoidance of rinsing and/or other post-ablation treatment is essential for performing metallization immediately after the ablation process is completed. In particular, rinsing and drying after ablation/etching would generally preclude the precise machine tooled registration of the subsequent metallization. Rinsing and drying also contribute to wafer breakage.

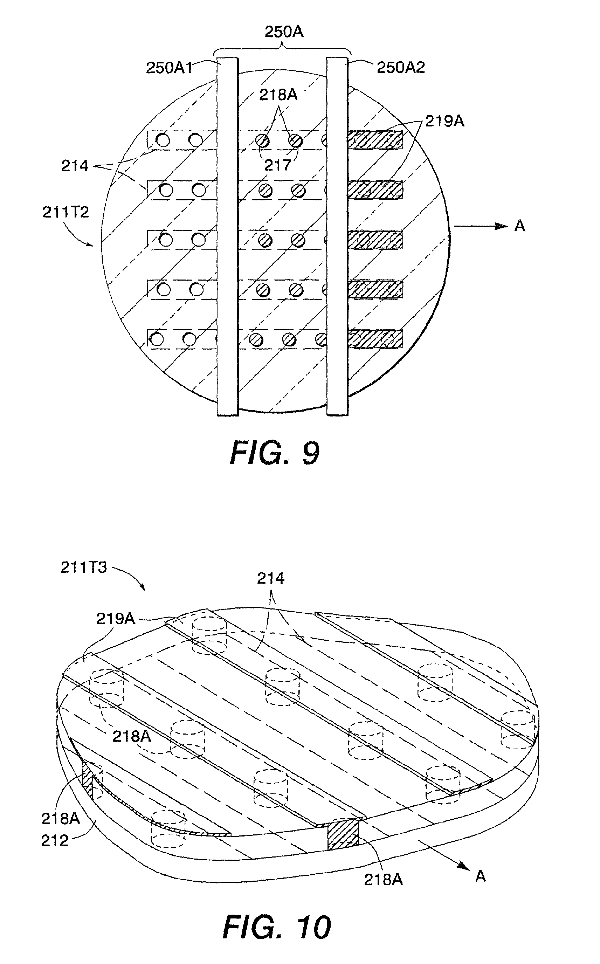

Fig. 9 depicts a simplified direct-write metallization device 250A according to another aspect of the present invention. As used herein, "direct-write metallization device" is defined as a device in which the metallization material is ejected, extruded, or otherwise deposited only onto the portions of the substrate where the metallization is needed (i.e., without requiring a subsequent mask and/or etching process to remove some of the metallization material). In the embodiment depicted in Fig. 9, direct-write metallization device 250A includes a first ejection head 250A1 that is used to deposit a contact (metallization) portion 218A into each opening 217 of device 211T2, and a second ejection head 250A2 immediately downstream from first ejection head 250A1 that is used to form current-carrying conductive lines 219A that extend over associated doped diffusion regions 214. Additional details and alternative embodiments related to direct-write metallization device 250A are disclosed in co-owned U.S. Patent Application Serial No. 11/336,714, entitled "SOLAR CELL PRODUCTION USING NON-CONTACT PATTERNING AND DIRECT-WRITE METALLIZATION", which is incorporated herein in its entirety.

In accordance with another aspect of the present invention, as indicated in Fig. 9, device 211T2 is passed under direct-write metallization device 250A in the moving direction A (i.e., in a direction parallel to doped regions 214). Because the present invention facilitates the non-contact formation of contact holes in a straight line over doped regions 214, immediate execution of the metallization process is greatly simplified, thus reducing overall manufacturing costs.

As indicated in Fig. 10, contact portions 218A facilitate electrical connection of current-carrying conductive lines 219A to the diffusion regions 214 formed in substrate 212. Upon completion of the metallization process by direct-write metallization apparatus 250A, devices 211T3 are transported to optional post metallization processing system 270 (Fig. 3).

Although the present invention has been described with respect to certain specific embodiments, it will be clear to those skilled in the art that the inventive features of the present invention are applicable to other embodiments as well, all of which are intended to fall within the scope of the present invention. For example, one or more of first optical element 123 and second optical element 125 may be implemented using an optical element other than a flat mirror (e.g., a curved mirror or a lens), and additional optical elements may be included in the light path between source 110 and focusing element 127. In addition, focusing element 127 may be implemented using one or more optical elements other than a microscope objective lens that facilitate the desired focusing function, and can be located anywhere along the light path between source 110 and focal point FP (e.g., between first optical element 123 and second optical element 125). Further, instead of rotating the scanner through complete revolutions, the scanner head portion 121-2 can be reciprocated (i.e., pivoted back-and-forth) over the target object. Moreover, as indicated in Fig. 1(B), instead of target object 101 by way of stage 140, the scanner head portion 121-2 can be moved in the radial direction (e.g., in the direction of dashed arrow B), although this repositioning of objective lens 127 may create undesirable focusing issues and/or complicate two dimensional scanning processes by changing the shape of scan path. In addition, although the invention is described with specific reference to solar cells having an integrated back contact (IBC) cell geometry (i.e., including elongated doped regions 214), the present invention may also be utilized to produce other solar cell types.

## Claims

1. A light scanning mechanism for redirecting a light beam that is transmitted along a central axis such that the light beam is scanned along a predetermined scan path defined on a target object, the light scanning mechanism comprising:
a rotating member having a first portion disposed to rotate around the central axis, the rotating member also having a second portion disposed away from the central axis;
a first optical element fixedly disposed on the first portion of the rotating member such that the central axis intersects a portion of the first optical element;
a second optical element disposed on the second portion of the rotating member; and
a focusing element disposed on the rotating member in fixed relation to the second optical element,
wherein the first and second optical elements are arranged such that the first optical element continuously redirects the light beam from the central axis to the second optical element while the rotating member is rotated around the central axis between a first angular position and a second angular position, and the focusing element is disposed to focus the light beam at a focal point that coincides with the predetermined scan path as the rotating member is rotated between the first and second angular positions,.

2. The light scanning mechanism according to Claim 1, wherein the first and second optical elements comprise mirrors having respective flat reflective surfaces that are parallel.

3. The light scanning mechanism according to Claim 2, wherein the focusing element comprises an objective lens disposed between the second mirror and the focal point.

4. The light scanning mechanism according to Claim 1, wherein the first optical element is disposed at a fixed distance from the second optical element.

5. The light scanning mechanism according to Claim 4, wherein the focusing element is disposed at a fixed distance from the second optical element.

6. The light scanning mechanism according to Claim 1, wherein the rotating member includes a central portion extending between the first optical element and the second optical element, and wherein the first and second optical elements are disposed to such that the first optical element redirects the light beam from the central axis to the second optical element through a central axial region of the central portion.

7. The light scanning mechanism according to Claim 1, wherein the rotating member further comprises a counterweight fixedly connected to the first portion and disposed such that the first portion is located between the counterweight and the second portion.

8. A laser ablation apparatus for ablating a selected material disposed on a target object, the laser ablation apparatus comprising:
a laser device for selectively generating a laser beam pulse along a central axis;
a stage for supporting the target object;
a laser scanning mechanism including:
a rotating member having a first portion disposed to rotate around the central axis, the rotating member also having a second portion disposed away from the central axis,
a first optical element fixedly disposed on the first portion of the rotating member such that the central axis intersects a portion of the first optical element,
a second optical element disposed on the second portion of the rotating member, and
a focusing element disposed on the rotating member in fixed relation to the second optical element,
wherein the first and second optical elements are arranged such that the first optical element redirects the laser beam pulse from the central axis to the second optical element, wherein the second optical element redirects the laser beam pulse received from the first optical element through the focusing element, and wherein the focusing element is disposed to focus the laser beam pulse such that the focal point coincides with the selected material disposed on the target object when the focusing element is disposed over the target object;
means for rotating the rotating member around the central axis between a first angular position and a second angular position such that focal point traces the predetermined scan path portion on the selected material as the rotating member is rotated between the first and second angular positions,; and
means for controlling the laser device to generate said laser beam pulse while the focal point is disposed on the predetermined scan path over a predetermined portion of the selected material, whereby the predetermined portion of the selected material is ablated.

9. The laser ablation apparatus of Claim 8,
wherein the first and second optical elements comprise mirrors having respective flat reflective surfaces that are parallel, and
wherein the focusing element comprises an objective lens disposed between the second mirror and the focal point.

10. A system for producing a photovoltaic device including a semiconductor substrate having a doped region diffused into a surface thereof, and a passivation layer disposed on the surface over the doped region, wherein the system comprises:
a laser device for selectively generating a laser beam pulse along a central axis;
a stage for supporting the semiconductor substrate;
a laser scanning mechanism including:
a rotating member having a first portion disposed to rotate around the central axis, the rotating member also having a second portion disposed away from the central axis,
a first optical element fixedly disposed on the first portion of the rotating member such that the central axis intersects a portion of the first optical element,
a second optical element disposed on the second portion of the rotating member, and
a focusing element disposed on the rotating member in fixed relation to the second optical element,
wherein the first and second optical elements are arranged such that the first optical element redirects the laser beam pulse from the central axis to the second optical element, wherein the second optical element redirects the laser beam pulse received from the first optical element through the focusing element toward the stage, and wherein the focusing element is disposed to focus the laser beam pulse such that the focal point coincides with the passivation layer when the focusing element is disposed over the semiconductor substrate,
means for rotating the rotating member around the central axis between a first angular position and a second angular position such that focal point traces the predetermined scan path portion on the passivation layer as the rotating member is rotated between the first and second angular positions,; and
means for controlling the laser device to generate said laser beam pulse while the focal point is disposed on the predetermined scan path over a predetermined portion of the passivation layer, whereby the predetermined portion of the passivation layer is ablated to define a contact opening.
